(19) Europäisches Patentamt / European Patent Office / Office européen des brevets

(11) **EP 3 593 937 A1**

(12) **EUROPEAN PATENT APPLICATION**
published in accordance with Art. 153(4) EPC

(43) Date of publication:
**15.01.2020 Bulletin 2020/03**

(51) Int Cl.:
*B23K 35/26* (2006.01)     *C22C 13/00* (2006.01)
*C22C 13/02* (2006.01)     *H05K 3/34* (2006.01)

(21) Application number: **18764657.5**

(22) Date of filing: **07.03.2018**

(86) International application number:
**PCT/JP2018/008723**

(87) International publication number:
**WO 2018/164171 (13.09.2018 Gazette 2018/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.03.2017   JP 2017046627**

(71) Applicant: **Tamura Corporation**
**Tokyo 178-8511 (JP)**

(72) Inventors:
• **ARAI Masaya**
**Iruma-shi**
**Saitama 358-0032 (JP)**
• **KATSUYAMA Tsukasa**
**Iruma-shi**
**Saitama 358-0032 (JP)**
• **MUNEKAWA Yurika**
**Iruma-shi**
**Saitama 358-0032 (JP)**
• **SHIMAZAKI Takanori**
**Iruma-shi**
**Saitama 358-0032 (JP)**

(74) Representative: **Cabinet Beau de Loménie**
**158, rue de l'Université**
**75340 Paris Cedex 07 (FR)**

(54) **LEAD-FREE SOLDER ALLOY, SOLDER PASTE, AND ELECTRONIC CIRCUIT BOARD**

(57)     Intended is to provide a lead-free solder alloy, a solder paste, and an electronic circuit board which inhibit thermomigration phenomenon, which tends to occur in a solder joint in a severe environment having drastic temperature changes (in particular, from -40°C to 150°C or higher) because of the inclusion of Sb, thereby ensuring connection reliability between a solder joint and electronic components over a long period, and achieves further better electrical insulation properties. In order to achieve the intention, the lead-free solder alloy of the present invention includes 1% by mass or more and 4% by mass or less of Ag, 0.1% by mass or more and 1% by mass or less of Cu, 1.5% by mass or more and 5% by mass or less of Sb, and 1% by mass or more and 6% by mass or less of In, the balance including Sn.

[FIG. 1]

L   x200   500 um

EP 3 593 937 A1

**Description**

Technical Field

The present invention relates to a lead-free solder alloy, a solder paste, and an electronic circuit board.

Background Art

As a method for joining electronic components to an electronic circuit formed on a substrate such as a printed circuit board or a silicon wafer, generally, a solder joining method using a solder alloy is used. In prior art, the solder alloy commonly includes lead. However, the use of lead was restricted by RoHS Directive and others from the viewpoint of environmental load, so that solder joining using a so-called lead-free solder alloy containing no lead is becoming common in recent years.

Examples of known lead-free solder alloys include Sn-Cu, Sn-Ag-Cu, Sn-Bi, and Sn-Zn solder alloys. Among them, the Sn-3Ag-0.5Cu solder alloy is often used in consumer electronic devices used in televisions and cellular telephones and in-vehicle electronic devices mounted on automobiles. The Sn-3Ag-0.5Cu solder alloy is somewhat inferior to lead-containing solder alloys in solderability, but the problem of solderability is solved by improvement of flux compositions and soldering apparatuses. Therefore, for example, on an in-vehicle electronic circuit board placed in an environment having relatively moderate temperature changes such as an automobile cabin, solder joints formed using a Sn-3Ag-0.5Cu solder alloy have not caused marked problems.

However, in recent years, installment of electronic circuit boards in environments such as installment in engine compartments, direct mounting on engines, or integration of a motor and a machine, or severe environments subjected to extremely drastic temperature changes (for example, temperature changes from -30°C to 110°C, from -40°C to 125°C, and from -40°C to 150°C) and vibration loads are under study and commercialization, as electronic circuit boards used in electronic controllers.

In such an environment having drastic temperature changes, heat displacement in a solder joint by the difference of the coefficients of linear expansion of the mounted electronic components and the substrate and the accompanying stress tend to occur. Additionally, repeated plastic deformation by temperature changes tends to cause cracks in a solder joint, and the stress repeatedly applied with the lapse of time concentrates in the vicinity of the tips of the cracks, so that the cracks tend to transversely develop to the deep portion of the solder joint. The cracks thus markedly developed can disconnect the electrical connection between the electronic components and the electronic circuit formed on the substrate. Inparticular, in an environment subjected to drastic temperature changes and vibration on the electronic circuit board, the cracks and their development further easily occur.

In the solder joining method, for example, when a solder paste prepared by mixing a solder alloy powder and a flux composition is used, there is washing system wherein the flux residue formed on the substrate is washed after solder joining and non-washing system wherein the flux residue is not washed. The non-washing system is preferred because it requires no washing process. However, when a halogen activator is included in the flux composition, anion components such as a halogen are likely to remain in the flux residue. Therefore, when an electronic device including a substrate having such a flux residue is used for a long period of time, the occurrence of ion migration in a conductor metal is accelerated, whereby the risk of inferior insulation between the wires of the substrate is increased.

In particular, in in-vehicle electronic devices required to have high reliability, flux residues will be increasingly demanded to have higher insulation properties.

In order to inhibit crack development in solder joints, some methods for improving strength of solder joints and accompanying heat fatigue properties through the addition of Bi or Sb to Sn-Ag-Cu solder alloys are disclosed (see Patent Literature 1 and Patent Literature 2).

Additionally, in order to improve insulation properties of flux residue, fluxes and solder compositions prepared by mixing a flux composition with a halogen activator and an inorganic ion exchanger are proposed (for example, see Patent Literature 3 and Patent Literature 4).

Citation List

Patent Literature

Patent Literature 1: Japanese Unexamined Patent Application Publication No. 5-228685
Patent Literature 2: Japanese Unexamined Patent Application Publication No. 2012-81521
Patent Literature 3: Japanese Unexamined Patent Application Publication No. 7-171696

Patent Literature 4: Japanese Unexamined Patent Application Publication No. 7-178590

When Bi or Sb is added to a lead-free solder alloy composed mainly of Sn, a portion of the Sn crystal lattice is substituted with Bi or Sb. As a result of this, the Sn matrix is reinforced to increase the alloy strength of the solder alloy, which improves its inhibitory effect on development of cracks only for cracks in the solder bulk.

On the other hand, when Sb is added to a lead-free solder alloy, its heat conductivity tends to be lower than a prior art Sn-3Ag-0.5Cu solder alloy. When a temperature difference occurs in a solder joint, a force for keeping the whole of the solder joint at a uniform temperature, and heat transfer from a high temperature region to a low temperature region occurs. So-called heat conductivity is a coefficient representing easiness of occurrence of heat transfer; the higher the value of heat conductivity, the greater amount of heat is transferred and the more easily heat is transferred, while the smaller the value of heat conductivity, the smaller amount of heat is transferred. Therefore, if the object is placed in an environment having drastic temperature changes, temperature gradients can occur in a solder joint.

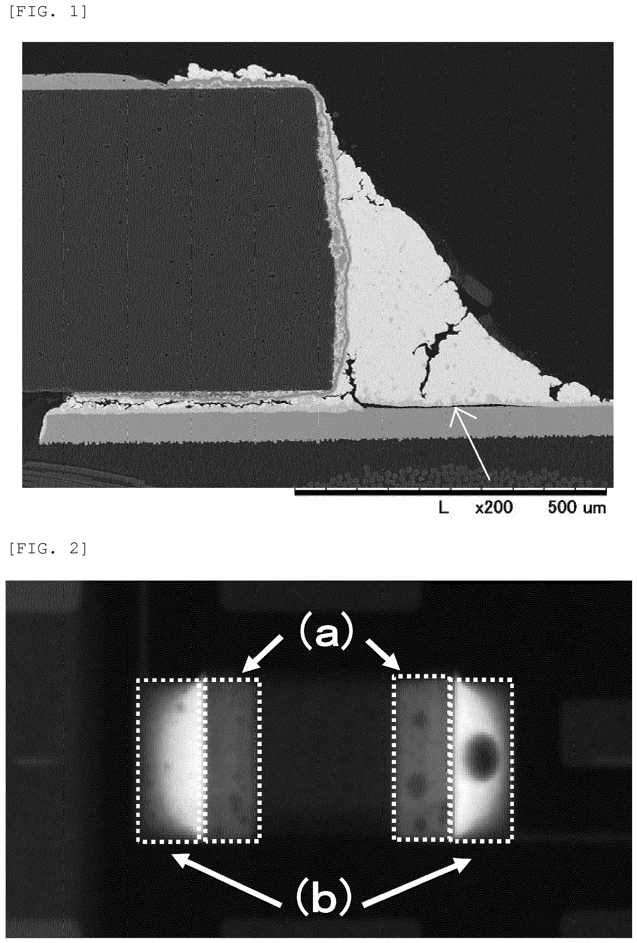

Commonly, Cu used in the formation of the electrode (land) at the substrate side has a heat conductivity of about 400 W/m-K, while that of Sb is as low as about 24 W/m-K, and that of Sn is about 67 W/m-K. Therefore, if an electrode composed of Cu, particularly Cu having a higher heat conductivity such as oxygen-free copper or tough pitch copper, is soldered using a Sb-containing lead-free solder alloy, a big difference can arise between the heat conductivity of the Cu electrode and that of the solder joint thus formed. Therefore, when a substrate having such a solder joint is placed in a thermal shock test apparatus and subjected to a heat cycle, the temperature of the alloy layer formed at the joining interface with the Cu electrode in the early stage increases, and a large temperature gradient can occur in the joint. In particular, in an actual use environment, an electric current flows into the Cu electrode, so that further temperature increase is assumed in the vicinity of the Cu electrode. Accordingly, in such an environment, in a solder joint having low heat conductivity, Cu moves from a higher temperature part to a lower temperature part, or toward the deep part of the solder joint, while Sn moves from a lower temperature part to a higher temperature part, so that Cu is consumed in a high temperature alloy layer (particularly $Cu_sSn$ layer) formed at the joining interface with the above-described Cu electrode. Holes occur in the region having consumed Cu (particularly the high temperature alloy layer formed at the joining interface with the Cu electrode), and the holes tend to continuously connect with each other with the increase of the number of the holes, and finally rupture of the alloy layer depicted in Fig. 1 occurs.

The phenomenon wherein elements migrate through alloys due to temperature gradients is referred to as "thermomigration phenomenon". In the experiment carried out by the present inventors (a solder joint was formed on a Cu electrode using a Sb-containing lead-free solder alloy), this phenomenon was markedly observed particularly in an environment at 150°C or higher.

However, in Patent Literature 1 and Patent Literature 2, the occurrence of and countermeasures against such phenomenon are not disclosed or suggested.

Additionally, even when soldering is carried out by a non-washing system using the solder compositions disclosed in Patent Literature 3 and Patent Literature 4, the insulation performance is not satisfactory.

Summary of Invention

Technical Problem

The present invention solves the above-described problems, and is intended to provide a lead-free solder alloy, a solder paste, and an electronic circuit board having a solder joint formed using the lead-free alloy which inhibits thermomigration phenomenon, which tends to occur in a solder joint in a severe environment having drastic temperature changes (in particular, from -40°C to 150°C or higher) because of the inclusion of Sb, thereby ensuring connection reliability between a solder joint and electronic components, and also exerts inhibitory effect on crack development to achieve durability of a solder joint over a long period of time, and further achieve good electrical insulation properties.

Solution to Problem

In order to achieve the above-described aim, the lead-free solder alloy, solder paste, and electronic circuit board according to the present invention have the following structures .

(1) The lead-free solder alloy according to the present invention includes 1% by mass or more and 4% by mass or less of Ag, 0.1% by mass or more and 1% by mass or less of Cu, 1.5% by mass or more and 5% by mass or less of Sb, and 1% by mass or more and 6% by mass or less of In, the balance including Sn.

(2) The structure of (1), wherein the lead-free solder alloy according to the present invention further includes 1% by mass or more and 5.5% by mass or less of Bi.

(3) The lead-free solder alloy according to the present invention includes 1% by mass or more and 4% by mass or less of Ag, 0.1% by mass or more and 1% by mass or less of Cu, 1.5% by mass or more and 5% by mass or less of Sb, 1% by mass or more and 6% by mass or less of In, 1% by mass or more and 5.5% by mass or less of Bi, the balance including Sn, and the contents of Ag, Cu, Sb, In, and Bi (%bymass) satisfying all of the following formulae (A) to (C).

$$(A)\ 0.84 \leq (Ag\ content/4) + Cu\ content \leq 1.82$$

$$(B)\ 0.71 \leq (In\ content/6) + (Sb\ content/5) \leq 1.67$$

$$(C)\ 0.29 \leq (Bi\ content/5) + (Sb\ content/5) \leq 1.79$$

(4) The structure of any one of (1) to (3), wherein the lead-free solder alloy according to the present invention further includes at least one of Fe, Mn, Cr, and Mo in a total amount of 0.001% by mass or more and 0.05% by mass or less.

(5) The structure of any one of (1) to (4), wherein the lead-free solder alloy according to the present invention further includes at least one of P, Ga, and Ge in a total amount of 0.001% by mass or more 0.05% by mass or less.

(6) The solder paste according to the present invention includes the lead-free solder alloy of any one of (1) to (5) and a flux composition.

(7) The electronic circuit board according to the present invention includes a solder joint formed using the lead-free solder alloy of any one of (1) to (5).

Advantageous Effects of Invention

The lead-free solder alloy, solder paste, and electronic circuit board, which has a solder joint formed using the lead-free solder alloy, of the present invention inhibit thermomigration phenomenon, which tends to occur in a solder joint in a severe environment having drastic temperature changes (in particular, from -40°C to 150°C or higher) because of the inclusion of Sb, thereby ensuring connection reliability between a solder joint and electronic components, and also exerts inhibitory effect on crack development to achieve durability of the solder joint over a long period of time, and further achieve good electrical insulation properties.

Brief Description of Drawings

Fig. 1 is a cross section photograph of a chip resistor taken using an X-ray inspection apparatus, wherein rupture of the alloy layer at the interface between a Cu electrode and a solder joint was caused by thermomigration phenomenon.

Fig. 2 is a photograph of a substrate equipped with common chip components taken from the side of the chip components using an X-ray inspection apparatus for indicating "the region under an electrode of a chip component" and "the region having a fillet" for observing the presence or absence of void occurrence in Examples of the present invention and Comparative Examples.

Description of Embodiments

Embodiments of the lead-free solder alloy, solder paste, and electronic circuit board of the present invention are described below in detail. The present invention will not be limited to the following embodiments.

(1) Lead-free solder alloy

The lead-free solder alloy of the present embodiment may include 1% by mass or more and 4% by mass or less of Ag. The addition of Ag within this range deposits an $Ag_3Sn$ compound in the Sn grain boundaries of the lead-free solder alloy, and imparts mechanical strength to the alloy. When the Ag content is 2% by mass or more and 3.8% by mass or less, the balance between the strength, drawability, and the cost of the lead-free solder alloy is further improved. The Ag content is even more preferably 2.5% by mass or more and 3.5% by mass or less.

However, it is not preferred that the Ag content is less than 1% by mass, because deposition of the $Ag_3Sn$

compound will be little, and the mechanical strength and thermal shock resistance of the lead-free solder alloy will decrease. It is also not preferred that the Ag content is more than 4% by mass, because drawability of the lead-free solder alloy will be inhibited, and heat and fatigue resistance of the solder joint formed using it may decrease.

The lead-free solder alloy of the present embodiment may include 0.1% by mass or more and 1% by mass or less of Cu. The addition of Cu within this range deposits a $Cu_6Sn_5$ compound in the Sn grain boundaries, and improves thermal shock resistance of the lead-free solder alloy.

In the present embodiment, the Cu content is particularly preferably 0.4% by mass or more and 0.8% by mass or less. When the Cu content is within this range, good thermal shock resistance is achieved while the occurrence of voids in a solder joint is suppressed.

However, it is not preferred that the Cu content is less than 0.1% by mass, because deposition of the $Cu_6Sn_5$ compound will be small, and the mechanical strength and thermal shock resistance of the lead-free solder alloy will decrease. It is also not preferred that the Cu content is more than 1% by mass, because drawability of the lead-free solder alloy will be inhibited, and heat and fatigue resistance of a solder joint using it may decrease.

Commonly, in a solder joint formed using a lead-free solder alloy containing Sn, Ag, and Cu, an intermetallic compound (for example, $Ag_3Sn$ and $Cu_6Sn_5$) disperses at the interfaces between Sn particles, and forms a structure which prevents the phenomenon of deformation caused by slip of Sn particles even when a tensile force is applied to the solder joint, whereby so-called mechanical properties are exerted. More specifically, the intermetallic compound prevents slip of the Sn particles.

Accordingly in the lead-free solder alloy of the present embodiment, when the Ag content is 1% by mass or more and 4% by mass or less, the Cu content is 0.1% by mass or more and 1% by mass or less, and the Ag content is not less than the Cu content, $Ag_3Sn$ as the intermetallic compound is easily formed, and good mechanical properties are achieved even if the Cu content is relatively low. Accordingly, even if the Cu content is 0.1% by mass or more and 1% by mass or less, it contributes to anti-slipping of $Ag_3Sn$ while a portion of it is turned to an intermetallic compound, whereby good mechanical properties are achieved in both of $Ag_3Sn$ and Cu.

The lead-free solder alloy of the present embodiment may include 1.5% by mass or more and 5% by mass or less of Sb. The addition of Sb within this range improves inhibitory effect on development of cracks in a solder joint without inhibiting drawability of the Sn-Ag-Cu solder alloy. In particular, when the Sb content is 3% by mass or more and 5% by mass or less, the inhibitory effect on development of cracks is further improved.

In order to make the solder joint resistant to external force applied by exposure to a severe environment having drastic temperature changes for a long time, it is likely effective to add an element which dissolves in a Sn matrix to the lead-free solder alloy for solid-solution strengthening, thereby increasing its strength and Young's modulus, and improving drawability. In order to solid-solution strengthen the lead-free solder alloy while ensuring sufficient strength, Young's modulus, and drawability, Sb is likely the optimum element.

More specifically, in the lead-free solder alloy according to the present embodiment, 3% by mass or more and 5% by mass or less of Sb is added to the lead-free solder alloy including Sn as an substantial base material to substitute a part of the crystal lattices of Sn with Sb, whereby a strain is occurred in the crystal lattice. Owing to this strain, in the solder joint formed using the lead-free solder alloy, the substitution of a part of the Sn crystal lattice with Sb increases the energy necessary for transfer in the crystal, and reinforces its metal structure. Furthermore, deposition of fine SnSb and $\varepsilon$-$Ag_3$ (Sn, Sb) compounds in the Sn grain boundaries prevents slip deformation of the Sn brain boundaries, and inhibits development of cracks occurring in the solder joint.

In comparison with a Sn-3Ag-0.5Cu solder alloy, the structure of the solder alloys formed using the lead-free solder alloy including Sb within the above-described range keeps fine Sn crystals even after exposure to a severe environment having drastic temperature changes for a long time, indicating that its structure inhibits development of cracks. The reason for this is likely that the SnSb and $\varepsilon$-$Ag_3$ (Sn, Sb) compounds deposited in the Sn grain boundaries are finely dispersed in the solder joint even after exposure to a severe environment having drastic temperature changes for a long time, whereby coarsening of Sn crystals is inhibited. More specifically, in a solder joint formed of the lead-free solder alloy containing Sb within the above-described range, dissolution of Sb into the Sn matrix occurred under high temperature conditions, and deposition of the SnSb and $\varepsilon$-$Ag_3$ (Sn, Sb) compounds occurs under low temperature conditions, so that the processes of solid-solution strengthening at high temperatures and deposition strengthening at low temperatures are repeated even when exposed to a severe environment having drastic temperature changes for a long time, whereby marked thermal shock resistance is likely ensured.

Further, the lead-free solder alloy containing Sb within the above-described range improves the strength of a Sn-3Ag-0.5Cu solder alloy without decreasing its drawability, whereby sufficient resistance against external force is ensured, and cracks in a solder joint is inhibited even when exposed to a severe environment having drastic temperature changes for a long time.

It is not preferred that the Sb content is less than 1.5% by mass, because sufficient solid-solution strengthening is hard to be achieved, and mechanical strength and thermal shock resistance of the lead-free solder alloy decrease. Additionally, if the Sb content is more than 5% by mass, the melting temperature of the lead-free solder alloy increases, and re-solution of Sb at high temperatures is hindered. Therefore, if a solder joint is exposed to a severe environment having drastic temperature changes a long time, only precipitation strengthening by SnSb and ε-Ag$_3$(Sn,Sb) compounds occurred, and these intermetallic compounds are coarsened with a lapse of time, whereby inhibitory effect on sliding deformation of Sn grain boundaries is lost. Such case is not preferred because the increase in the melting temperature of the lead-free solder alloy causes the problem of the heat resistance temperature of electronic components.

The lead-free solder alloy of the present embodiment may include 1% by mass or more and 6% by mass or less of In.

As described above, in order to make the solder joint resistant against an external force after being exposed to a severe environment having drastic temperature changes for a long period, solid-solution strengthening by the addition of Bi, Sb, or other element which solves in a Sn matrix is effective. However, the addition of such element to the lead-free solder alloy improves control of the deformation by stress (improvement of strength and Young's modulus on a stress-distortion curve) and drawability, but tends to cause "thermomigration phenomenon" resulted from the temperature gradient in a solder joint caused by the addition of Sb.

However, as described above, the lead-free solder alloy of the present embodiment includes 1% by mass or more and 6% by mass or less of In, whereby the melting temperature of the lead-free solder alloy increased by the addition of Sb is decreased, and the alloy layer formed at the interface with the Cu electrode turns from Cu$_6$Sn$_5$ to Cu$_6$(SnIn)$_5$. Therefore, even if a temperature gradient occurs in a solder joint, transfer of Cu, Sn caused by thermomigration phenomenon is inhibited, and rupture of the solder joint can be inhibited.

Furthermore, when a solder joint is formed using a solder paste including the lead-free solder alloy of the present embodiment and the below-described flux composition, the In in the solder joint is more easily eluted into flux residue than other elements. In addition, the eluted In is oxidized to form an oxide and functions as an insulating component, and can ensure electrical reliability of the flux residue.

In particular, when the In content is 2% by mass or more and 6% by mass or less, more preferably 3% by mass or more and 6% by mass or less, an alloy layer including In (Cu$_6$(SnIn)$_5$) is easily formed in a solder joint, transfer of Cu and Sn is further inhibited, and the inhibitory effect on consumption of the alloy layer and rupture of a solder joint is improved.

However, it is not preferred that the In content is less than 1% by mass, because the change (formation) of Cu$_6$(SnIn)$_5$ alloy layer from the Cu$_6$Sn$_5$ may be insufficient, and the inhibitory effect on thermomigration phenomenon may decrease. It is also not preferred that the In content is more than 6%, because drawability of the lead-free solder alloy may be inhibited, and furthermore, γ-InSn$_4$ tends to be formed in a solder joint when exposed to a severe environment having drastic temperature changes (for example, from -40°C to 150°C) for a long time, whereby the solder joint tends to cause self deformation.

The lead-free solder alloy of the present embodiment may include 1% by mass or more and 5.5% by mass or less of Bi. As described above, the addition of Bi within this range improves the strength of the lead-free solder alloy by solid solution of Bi in the Sn matrix, and decreases the melting temperature which has been increased by the addition of Sb.

In particular, when the Bi content is 2% by mass or more and 5% by mass or less, more preferably 3% by mass or more and 5% by mass or less, the balance between strength improvement and drawability of the lead-free solder alloy can be maintained.

However, it is not preferred that the Bi content is less than 1% by mass, because the effect of strength improvement by the solution of Bi into the Sn matrix is hard to be achieved, and mechanical strength and thermal shock resistance of the lead-free solder alloy are hard to be achieved. Furthermore, if the Bi content is more than 5.5% by mass, drawability of the lead-free solder alloy decreases and the alloy can be too brittle. Therefore, a solder joint formed from such lead-free solder alloy is not preferred because its fillet part tends to be cracked straightly when exposed to a severe environment having drastic temperature changes for a long time, which can cause short circuits.

When the lead-free solder alloy of the present embodiment includes Ag, Cu, Sb, In, Bi, and Sn, the Ag content is 1% by mass or more and 4% by mass or less, the Cu content is 0.1% by mass or more and 1% by mass or less, the Sb content is 1.5% by mass or more and 5% by mass or less, the In content is 1% by mass or more and 6% by mass or less, and the Bi content is 1% by mass or more and 5.5% by mass or less, the balance including Sn, and the contents of Ag, Cu, Sb, In, and Bi (%by mass) preferably satisfy all of the following formulae (A) to (C).

$$(A)\ \ 0.84 \leq (Ag\ content/4) + Cu\ content \leq 1.82$$

$$(B)\ \ 0.71 \leq (In\ content/6) + (Sb\ content/5) \leq 1.67$$

$$(C) \quad 0.29 \leq (Bi\ content/5) + (Sb\ content/5) \leq 1.79$$

When the contents of Ag, Cu, Sb, In, Bi, and Sn are within the above-described ranges, thermomigration phenomenon, which tends to occur in a solder joint in a severe environment having drastic temperature changes because of the inclusion of Sb, is further inhibited, so that connection reliability between a solder joint and an electronic component is ensured, and crack inhibitory effect is also exerted, whereby durability of the solder joint is achieved over a long period of time . Additionally, the flux residues formed using the lead-free solder alloy and the solder paste including the below-described flux composition achieves further better electrical insulation properties.

The lead-free solder alloy of the present embodiment may further include at least one of Fe, Mn, Cr, and Mo in a total amount of 0.001% by mass or more and 0.05% by mass or less. The addition of them within this range improves the inhibitory effect on crack development in the lead-free solder alloy. However, if the total of their contents is more than 0.05% by mass, the melting temperature of the lead-free solder alloy increases, and voids may easily open in a solder joint.

Additionally, the lead-free solder alloy of the present embodiment may include at least one of P, Ga, and Ge in a total amount of 0.001% by mass or more and 0.05% by mass or less. The addition of them within this range prevents oxidation of the lead-free solder alloy. However, if the total content of them is more than 0.05% by mass, the melting temperature of the lead-free solder alloy may increase, and voids tend to occur in a solder joint.

The lead-free solder alloy of the present embodiment may include other components (elements) such as Cd, Tl, Se, Au, Ti, Si, Al, Mg, and Zn within the range which will not inhibit its effect. The lead-free solder alloy of the present embodiment naturally also includes unavoidable impurities.

In the lead-free solder alloy of the present embodiment, the balance preferably includes Sn. The Sn content is preferably 78.9% by mass or more and 96.4% by mass or less.

(2) Solder paste composition

The solder paste of the present embodiment preferably includes an alloy powder made of the lead-free solder alloy, and a flux composition including a base resin (A), an activator (B), a thixotropic agent (C), and a solvent (D).

(A) Base resin

The base resin (A) is preferably, for example, a rosin resin (A-1).

Examples of the rosin resin (A-1) include rosin such as tall oil rosin, gum rosin, and wood rosin; rosin derivatives obtained by polymerization, hydrogenation, disproportionation, acrylation, maleinization, esterification, or phenol addition reaction of rosin; and modified rosin resins obtained by diels-alder reaction of these rosin or rosin derivatives with unsaturated carboxylic acids (for example, acrylic acid, methacrylic acid, maleic acid anhydride, and fumaric acid). Among them, modified rosin resins are preferably used, and hydrogenated acrylic acid modified rosin resins hydrogenated by reaction with an acrylic acid are particularly preferably used. These compounds may be used alone or in combination of two or more of them.

The acid value of the rosin resin (A-1) is preferably from 140 mgKOH/g to 350 mgKOH/g, and the weight average molecular weight is preferably from 200 Mw to 1,000 Mw.

As the base resin (A), in addition to the rosin resin (A-1), a synthetic resin (A-2) may be used.

Examples of the synthetic resin (A-2) include acrylic resin, styrene-maleic acid resins, epoxy resins, urethane resins, polyester resins, phenoxy resins, terpene resins, polyalkylene carbonate, and derivative compounds prepared by dehydration condensation of a carboxylic rosin resin and a dimer acid derivative flexible alcohol compound. These compounds may be used alone or in combination of two or more of them. Among them, acrylic resins are preferred.

The acrylic resin is obtained by, for example, homopolymerization of a (meth) acrylate having a $C_{1-20}$ alkyl group, or copolymerization of monomers composed mainly of the acrylate. Among these acrylic resins, acrylic resins obtained by polymerizing methacrylic acid with monomers including a monomer having two linear saturated $C_{2-20}$ alkyl groups are particularly preferred. The acrylic resins may be used alone or in combination of two or more of them.

Regarding the derivative compounds obtained by dehydration condensation of a carboxylic rosin resin and a dimer acid derivative flexible alcohol compound (hereinafter referred to as "rosin derivative compound"), firstly, examples of the carboxylic rosin resin include rosin such as tall oil rosin, gum rosin, and wood rosin; and rosin derivatives such as hydrogenated rosin, polymerized rosin, disproportionated rosin, acrylic acid modified rosin, and maleic acid modified rosin; other rosin may be used as long as it has a carboxyl group. These compounds may be used alone or in combination of two or more of them.

Examples of the dimer acid derivative flexible alcohol compound include compounds which are derived from dimer acid and have alcohol groups at their ends, such as dimer diol, polyester polyol, and polyester dimer diol. For example, PRIPOL2033, PRIPLAST3197, and PRIPLAST1838 (CRODA Japan) may be used.

The rosin derivative compound can be obtained by dehydration condensation of the carboxylic rosin resin with the dimer acid derivative flexible alcohol compound. The method of dehydration condensation may be a commonly used method. The preferred weight percentage in dehydration condensation of the carboxylic rosin resin and the dimer acid derivative flexible alcohol compound is from 25:75 to 75:25.

The acid value of the synthetic resin (A-2) is preferably from 0 mgKOH/g to 150 mgKOH/g, and the weight average molecular weight is preferably from 1,000 Mw to 30,000 Mw.

The loading of the base resin (A) is preferably from 10% by mass or more and 60% by mass or less with reference to the total amount of the flux composition, and more preferably 30% by mass or more and 55% by mass or less.

When the rosin resin (A-1) is used alone, the loading is preferably 20% by mass or more and 60% by mass or less, and more preferably 30% by mass or more and 55% by mass or less with reference to the total amount of the flux composition. When the loading of the rosin resin (A-1) is within this range, flux residue exerts good electrical insulation properties.

When the synthetic resin (A-2) is used alone, its loading is preferably 10% by mass or more and 60% by mass or less, and more preferably 30% by mass or more and 55% by mass or less with reference to the total amount of the flux composition.

When the rosin resin (A-1) and the synthetic resin (A-2) used in combination, the compounding ratio is preferably from 20:80 to 50:50, and more preferably from 25:75 to 40:60.

As a base resin (A), the rosin resin (A-1) is preferably used alone, or the combination of the rosin resin (A-1) and the synthetic resin (A-2) may be preferably used.

(B) Activator

Examples of the activator (B) include amine salts such as hydrogen halide salts (inorganic acid salts and organic acid salts) of organic amines, organic acids, organic acid salts, and organic amine salts. Specific examples include diphenylguanidine hydrobromide, cyclohexylamine hydrobromide, diethylamine salts, dimer acids, levulinic acid, lactic acid, acrylic acid, benzoic acid, salicylic acid, anisic acid, citric acid, 1,4-cyclohexane dicarboxylic acid, anthranilic acid, picolinic acid, and 3-hydroxy-2-naphthoic acid. These compounds may be used alone or in combination of two or more of them.

The loading of the activator (B) is preferably 0.1% by mass or more and 30% by mass or more, and more preferably, 2% by mass or more and 25% by mass or less with reference to the total amount of the flux composition.

The solder paste of the present embodiment may include, as the activator (B), 0.5% by mass or more 3% by mass or less of a linear saturated $C_{3-4}$ dicarboxylic acid (B-1) with reference to the total amount of the flux composition, 2% by mass or more 15% by mass or less of a $C_{5-13}$ dicarboxylic acid (B-2) with reference to the total amount of the flux composition, and 2% by mass or more 15% by mass or less of a $C_{20-22}$ dicarboxylic acid (B-3) with reference to the total amount of the flux composition.

The linear saturated $C_{3-4}$ dicarboxylic acid (B-1) is preferably malonic acid and/or succinic acid.

The loading of the linear saturated $C_{3-4}$ dicarboxylic acid (B-1) is more preferably from 0.5% by mass to 2% by mass with reference to the total amount of the flux composition.

The carbon chain in the $C_{5-13}$ dicarboxylic acid (B-2) may be linear or branched, and is preferably at least one selected from glutaric acid, adipic acid, pimelic acid, suberic acid, azelaic acid, 2-methylazelaic acid, sebacic acid,undecanedioic acid, 2,4-dimethyl-4-methoxycarbonyl undecanedioic acid, dodecanedioic acid, tridecanedioic acid, and 2,4,6-trimethyl-4,6-dimethoxycarbonyl tridecanedioic acid. Among them, adipic acid, suberic acid, sebacic acid, and dodecanedioic acid are particularly preferred.

The loading pf the $C_{5-13}$ dicarboxylic acid (B-2) is more preferably from 3% by mass to 12% by mass with reference to the total amount of the flux composition.

The carbon chain in the $C_{20-22}$ dicarboxylic acid (B-3) may be linear or branched, and is preferably at least one selected from eicosadioic acid, 8-ethyl octadecanedioic acid, 8,13-dimethyl-8,12-eicosadiene diacid, and 11-vinyl-8-octadecenodiacid.

The $C_{20-22}$ dicarboxylic acid (B-3) in a liquid or semi-solid state at room temperature is more preferably used. In the present description, the term "normal temperature" refers to the range from 5°C to 35°C. The term "semi-solid" refers to a state which is intermediate between a liquid and a solid, and a portion of it has mobility or no mobility but is deformed upon application of an external force. As the $C_{20-22}$ dicarboxylic acid (B-3), 8-ethyl octadecanedioic acid is particularly preferably used.

The loading of the $C_{20-22}$ dicarboxylic acid (B-3) is more preferably from 3% by mass to 12% by mass with reference to the total amount of the flux composition.

Through the inclusion of the activators (B-1), (B-2), and (B-3) as the activator (B) in the above-described amounts, the solder paste of the present embodiment sufficiently removes its oxide film even when an alloy powder composed of a lead-free solder alloy containing a highly oxidizing In or Bi, improves the cohesive force between alloy powder particles, and reduces the viscosity during solder melting, whereby the occurrence of solder balls at the sides of electronic components and the occurrence of voids in a solder joint are reduced.

More specifically, when the flux composition and the alloy powder are mixed, a part of the linear saturated $C_{3-4}$ dicarboxylic acid (B-1) coats the surface of the alloy powder to inhibit its surface oxidation, the $C_{20-22}$ dicarboxylic acid (B-3) has low reactivity and thus is stable in the printing process of the solder paste on a substrate over a long time, and is hard to volatilize during reflow heating, and thus covers the surface of the molten alloy powder and inhibit oxidation through reduction action.

The $C_{20-22}$ dicarboxylic acid (B-3) has low activity, so that its combination with the linear saturated $C_{3-4}$ dicarboxylic acid (B-1) alone cannot sufficiently remove the oxide film from the surface of the alloy powder. Therefore, when the alloy powder including a highly oxidizing element such as In or Bi is used, oxidative effect on the alloy powder will be insufficient, and its inhibitory effect on solder balls and voids may not be sufficiently exerted. However, the flux composition includes the $C_{5-13}$ dicarboxylic acid (B-2), which exerts strong activating force from the time of preheating, within the above-described range, so that sufficiently removes oxide film while ensuring reliability of flux residue, even when the alloy powder including highly oxidizing In or Bi is used. Therefore, the solder paste including such activator improves the cohesive force between the alloy powders, and reduces the viscosity during solder melting, thereby reducing solder balls occurring at the side of electronic components and voids occurring in a solder joint.

When, as the activator (B), the linear saturated $C_{3-4}$ dicarboxylic acid (B-1), the $C_{5-13}$ dicarboxylic acid (B-2), or the $C_{20-22}$ dicarboxylic acid (B-3) is used, the loading is preferably 4.5% by mass or more and 35% by mass or less, and is more preferably 4.5% by mass or more and 25% by mass or less.

In this case, the loading of the activator other than them is preferably more than 0% by mass and 20% by mass or less with reference to the total amount of the flux composition.

(C) Thixotropic agent

Examples of the thixotropic agent (C) include hydrogenated castor oil, fatty acid amides, saturated fatty acid bisamides, oxy fatty acid, and dibenzylidene sorbitols. These compounds may be used alone or in combination of two or more of them.

The loading of the thixotropic agent (C) is preferably 2% by mass or more and 15% by mass or less, and more preferably 2% by mass or more and 10% by mass or less with reference to the total amount of the flux composition.

(D) Solvent

Examples of the solvent (D) include isopropyl alcohol, ethanol, acetone, toluene, xylene, ethyl acetate, ethyl cellosolve, butyl cellosolve, hexyl diglycol, (2-ethylhexyl) diglycol, phenylglycol, butylcarbitol, octanediol, αterpineol, β terpineol, tetraethylene glycol dimethyl ether, trimellitic acid tris (2-ethylhexyl), and bisisopropyl sebacate. These compounds may be used alone or in combination of two or more of them.

The loading of the solvent (D) is preferably 20% by mass or more and 50% by mass or less, and more preferably 25% by mass or more and 40% by mass or less with reference to the total amount of the flux composition.

The flux composition may include an antioxidant for preventing oxidation of the alloy powder. Examples of the antioxidant include hindered phenol antioxidants, phenol antioxidants, bisphenol antioxidants, and polymer antioxidants. Among them, hindered phenol oxidants are particularly preferred. These compounds may be used alone or in combination of two or more of them.

The loading of the antioxidant is not particularly limited, but is generally 0.5% by mass or more and about 5% by mass or less with reference to the total amount of the flux composition.

The flux composition may include an additive as necessary. Examples of the additive include an anti-foaming agent, a surfactant, a delustering agent, and an inorganic filler. These compounds may be used alone or in combination of two or more of them.

The loading of the additive is preferably 0.5% by mass or more and 20% by mass or less, and is more preferably 1% by mass or more and 15% by mass or less with reference to the total amount of the flux composition.

The solder paste of the present embodiment is obtained by, for example, mixing the alloy powder and the flux composition.

The compounding ratio between the alloy powder and the flux composition is preferably from 65:35 to 95:5, more preferably from 85:15 to 93:7, and particularly preferably from 87:13 to 92:8 in terms of the ratio between the alloy powder : flux composition.

The average particle size of the alloy powder is preferably 1 μm or more and 40 μm or less, and 5 μm or more and 35 μm or less, and particularly preferably 10 μm or more and 30 μm or less.

(3) Electronic circuit board

The electronic circuit board of the present embodiment preferably include a solder joint formed using the lead-free solder alloy.

The electronic circuit board includes a substrate, electronic components having external electrodes, a solder resist film and electrodes formed on the substrate, a solder joint electrically connecting the electrodes and the external electrodes, and flux residues remaining adjacent to the solder joint. The formation of the solder joint and flux residue may use various soldering methods such as a flow method, a reflow method, and a solder ball mounting method. Among them, the soldering method by the reflow method using the solder paste is preferably employed. In the reflow method, the solder paste is printed using a mask having a predetermined pattern, electronic components conforming to the pattern are mounted at predetermined positions, and they are subjected to reflow soldering, thereby making the solder joint and flux residue.

The electronic circuit board of the present embodiment have a solder joint formed using the lead-free solder alloy, so that it inhibits thermomigration phenomenon which tends to be caused in a solder joint by the addition of Sb in a severe environment having drastic temperature changes, ensures connection reliability between a solder joint and an electronic component, and exerts inhibitory effect on crack development, thereby achieving durability of the solder joint over a long period of time. Additionally, the In contained in the solder joint is eluted into the flux residue, so that the flux residue achieves good electrical insulation properties.

The electronic circuit board having the solder joint and flux residue is also suitable as an electronic circuit board required to have high reliability, such as an in-vehicle electronic circuit board.

Through the incorporation of the electronic circuit board, an electronic controller is produced.

Examples

The present invention is described below in detail with reference to examples and comparative examples. The present invention will not be limited to these examples.

Making of flux composition

<Flux composition A>

The components listed in Table 1 are mixed to obtain a flux composition A. Unless otherwise specified, the unit of the loading in Table 1 is % by mass.

[Table 1]

| (A) Base resin | KE-604 *1 | 51 |
|---|---|---|
| (B) Activator | Dodecanedioic acid | 10 |
| | Malonic acid | 1 |
| | Diphenylguanidine hydrobromide | 2 |
| (C) Thixotropic agent | Hardened castor oil | 6 |
| (D) Solvent | Diethylene glycol monohexyl ether | 29 |
| Antioxidant | IRGANOX 245 *2 | 1 |
| *1 Hydrogenated acid modified rosin manufactured by Arakawa Chemical Industries, Ltd. *2 Hindered phenol antioxidant manufactured by BASF JAPAN LTD. | | |

<Flux composition B>

The components listed in Table 2 are mixed to obtain a flux composition B. Unless otherwise specified, the unit of the loading in Table 2 is % by mass.

[Table 2]

| (A) Base Resin | KE-604 *1 | 51 |
|---|---|---|

(continued)

| | | |
|---|---|---|
| (B) Activator | Malonic acid | 1 |
| | Succinic acid | 1 |
| | Suberic acid | 3 |
| | Dodecanedioic acid | 6 |
| | 8-ethyloctadecane diacid | 6 |
| | 2-bromohexanoic acid | 1.5 |
| (C) Thixotropic agent | SLIPAX ZHH *2 | 4 |
| (D) Solvent | Diethylene glycol monohexyl ether | 25.5 |
| Antioxidant | IRGANOX 245 *3 | 1 |
| *1 Hydrogenated acid modified rosin, Arakawa Chemical Industries, Ltd. | | |
| *2 Hexamethylene bis-hydroxystearic acid amide, Nippon Kasei Chemical Co., Ltd. | | |
| *3 Hindered phenol antioxidant, BASF JAPAN LTD. | | |

Making of solder paste

11% by mass of the flux composition A and 89% by mass of the lead-free solder alloy powders listed in Table 3 to Table 5 (powder particle size 20 μm to 38 μm) were mixed, thereby making the solder pastes A according to Examples 1 to 43 and Comparative Examples 1 to 19.

Additionally, 11% by mass of the flux composition B and 89% by mass of any of the lead-free solder alloy powders according to Example 1 to Example 16, and Example 22 to Example 29 (powder particle size: 20 μm to 38 μm) of those listed in Table 3 and Table 4 were mixed, thereby making the solder pastes B according to Example 1 to Example 16, and Example 22 to Example 29.

[Table 3]

| | Sn | Ag | Cu | Sb | In | Bi | Others |
|---|---|---|---|---|---|---|---|
| Example 1 | Balance | 3.0 | 0.7 | 1.5 | 3.0 | - | - |
| Example 2 | Balance | 3.0 | 0.7 | 3.0 | 3.0 | - | - |
| Example 3 | Balance | 3.0 | 0.7 | 5.0 | 3.0 | - | - |
| Example 4 | Balance | 3.0 | 0.7 | 3.0 | 1.0 | - | - |
| Example 5 | Balance | 3.0 | 0.7 | 3.0 | 2.0 | - | - |
| Example 6 | Balance | 3.0 | 0.7 | 3.0 | 5.0 | - | - |
| Example 7 | Balance | 3.0 | 0.7 | 3.0 | 6.0 | - | - |
| Example 8 | Balance | 1.0 | 0.7 | 3.0 | 3.0 | - | - |
| Example 9 | Balance | 2.0 | 0.7 | 3.0 | 3.0 | - | - |
| Example 10 | Balance | 2.5 | 0.7 | 3.0 | 3.0 | - | - |
| Example 11 | Balance | 3.5 | 0.7 | 3.0 | 3.0 | - | - |
| Example 12 | Balance | 4.0 | 0.7 | 3.0 | 3.0 | - | - |
| Example 13 | Balance | 3.0 | 0.1 | 3.0 | 3.0 | - | - |
| Example 14 | Balance | 3.0 | 0.4 | 3.0 | 3.0 | - | - |
| Example 15 | Balance | 3.0 | 0.8 | 3.0 | 3.0 | - | - |
| Example 16 | Balance | 3.0 | 1.0 | 3.0 | 3.0 | - | - |
| Example 17 | Balance | 1.0 | 0.5 | 3.0 | 3.0 | - | - |
| Example 18 | Balance | 3.8 | 1.0 | 3.0 | 3.0 | - | - |

(continued)

|  | Sn | Ag | Cu | Sb | In | Bi | Others |
|---|---|---|---|---|---|---|---|
| Example 19 | Balance | 3.0 | 0.7 | 1.0 | 2.0 | - | - |
| Example 20 | Balance | 3.0 | 0.7 | 6.0 | 5.0 | - | - |
| Example 21 | Balance | 3.8 | 1.0 | 6.0 | 5.0 | - | - |
| Example 22 | Balance | 3.0 | 0.7 | 3.0 | 3.0 | 1.0 | - |

[Table 4]

|  | Sn | Ag | Cu | Sb | In | Bi | Others |
|---|---|---|---|---|---|---|---|
| Example 23 | Balance | 3.0 | 0.7 | 3.0 | 3.0 | 2.0 | - |
| Example 24 | Balance | 3.0 | 0.7 | 3.0 | 3.0 | 3.0 | - |
| Example 25 | Balance | 3.0 | 0.7 | 3.0 | 3.0 | 5.0 | - |
| Example 26 | Balance | 3.5 | 0.7 | 3.0 | 3.0 | 3.0 | - |
| Example 27 | Balance | 3.5 | 0.7 | 3.0 | 6.0 | 3.0 | - |
| Example 28 | Balance | 3.8 | 0.7 | 3.0 | 3.0 | 3.0 | - |
| Example 29 | Balance | 4.0 | 0.7 | 3.0 | 3.0 | 3.0 | - |
| Example 30 | Balance | 3.0 | 0.7 | 3.0 | 3.0 | 5.5 | - |
| Example 31 | Balance | 1.0 | 0.5 | 2.0 | 1.0 | 2.0 | - |
| Example 32 | Balance | 3.8 | 1.0 | 4.0 | 6.0 | 5.0 | - |
| Example 33 | Balance | 1.0 | 0.5 | 4.0 | 3.0 | 5.0 | - |
| Example 34 | Balance | 3.8 | 1.0 | 4.0 | 3.0 | 5.0 | - |
| Example 35 | Balance | 3.0 | 0.7 | 1.0 | 1.0 | 2.0 | - |
| Example 36 | Balance | 3.0 | 0.7 | 4.0 | 6.0 | 5.0 | - |
| Example 37 | Balance | 3.0 | 0.7 | 3.0 | 3.0 | 3.0 | 0.05P |
| Example 38 | Balance | 3.0 | 0.7 | 3.0 | 3.0 | 3.0 | 0.05Ge |
| Example 39 | Balance | 3.0 | 0.7 | 3.0 | 3.0 | 3.0 | 0.05Ga |
| Example 40 | Balance | 3.0 | 0.7 | 3.0 | 3.0 | 3.0 | 0.05Fe |
| Example 41 | Balance | 3.0 | 0.7 | 3.0 | 3.0 | 3.0 | 0.05Mn |
| Example 42 | Balance | 3.0 | 0.7 | 3.0 | 3.0 | 3.0 | 0.05Cr |
| Example 43 | Balance | 3.0 | 0.7 | 3.0 | 3.0 | 3.0 | 0.05Mo |

[Table 5]

|  | Sn | Ag | Cu | Sb | In | Bi | Others |
|---|---|---|---|---|---|---|---|
| Comparative Example 1 | Balance | 3.0 | 0.5 | - | - | - | - |
| Comparative Example 2 | Balance | 3.0 | 0.7 | 1.0 | - | - | - |
| Comparative Example 3 | Balance | 3.0 | 0.7 | 3.0 | - | - | - |
| Comparative Example 4 | Balance | 3.0 | 0.7 | 1.0 | 3.0 | - | - |
| Comparative Example 5 | Balance | 3.0 | 0.7 | 6.0 | 3.0 | - | - |
| Comparative Example 6 | Balance | 3.0 | 0.7 | 3.0 | 0.5 | - | - |

(continued)

|  | Sn | Ag | Cu | Sb | In | Bi | Others |
|---|---|---|---|---|---|---|---|
| Comparative Example 7 | Balance | 3.0 | 0.7 | 3.0 | 6.5 | - | - |
| Comparative Example 8 | Balance | 0.5 | 0.7 | 3.0 | 3.0 | - | - |
| Comparative Example 9 | Balance | 4.5 | 0.7 | 3.0 | 3.0 | - | - |
| Comparative Example 10 | Balance | 3.0 | - | 3.0 | 3.0 | - | - |
| Comparative Example 11 | Balance | 3.0 | 1.5 | 3.0 | 3.0 | - | - |
| Comparative Example 12 | Balance | 3.0 | 0.7 | 3.0 | 3.0 | 6.0 | - |
| Comparative Example 13 | Balance | 3.0 | 0.7 | 3.0 | 3.0 | 3.0 | 0.1P |
| Comparative Example 14 | Balance | 3.0 | 0.7 | 3.0 | 3.0 | 3.0 | 0.1Ge |
| Comparative Example 15 | Balance | 3.0 | 0.7 | 3.0 | 3.0 | 3.0 | 0.1Ga |
| Comparative Example 16 | Balance | 3.0 | 0.7 | 3.0 | 3.0 | 3.0 | 0.1Fe |
| Comparative Example 17 | Balance | 3.0 | 0.7 | 3.0 | 3.0 | 3.0 | 0.1Mn |
| Comparative Example 18 | Balance | 3.0 | 0.7 | 3.0 | 3.0 | 3.0 | 0.1Cr |
| Comparative Example 19 | Balance | 3.0 | 0.7 | 3.0 | 3.0 | 3.0 | 0.1Mo |

(1) Solder crack test (from -40°C to 150°C)

A glass epoxy substrate equipped with a chip component with a size of 2.0 mm x 1.2 mm, a solder resist having a pattern which can mount a chip component of the size, and an electrode for connecting the chip component (a Cu electrode (1.25 mm x 1.0 mm) plated with tough pitch copper), and a metal mask with a thickness of 150 $\mu$m having the same pattern with the substrate was provided.

On each of the glass epoxy substrates, the solder paste A was printed using the metal mask, and the chip component was mounted.

Thereafter, the glass epoxy substrates was heated using a reflow furnace (product name: TNP40-577PH, TAMURA Corporation), and a solder joint electrically joining the glass epoxy substrate and the chip component was formed on each of them, and the chip component was mounted thereon. The reflow conditions at this time are as follows: preheating at 170°C to 190°C for 110 seconds, the peak temperature was 245°C, the period at 200°C or higher was 65 seconds, the period at 220°C or higher was 45 seconds, the cooling rate from the peak temperature to 200°C was from 3°C to 8°C/second, and the oxygen concentration was adjusted at 1500 $\pm$ 500 ppm.

Subsequently, using a thermal shock test apparatus (Product name: ES-76LMS, Hitachi Appliances, Inc.) adjusted at -40°C (30 minutes) to 150°C (30 minutes), each of the glass epoxy substrate was exposed to an environment repeating 2,000 thermal shock cycles, and then the substrate was taken out, thereby making a test substrate.

Subsequently, the target part of each test substrate was cut out, and sealed with an epoxy resin (product name: EPOMOUNT (main agent and curing agent), Refine Tec Ltd.). Furthermore, using a wet polishing machine (product name: TegraPol-25, Marumoto Struers K.K.), the central cross section of the chip component mounted on each test substrate was made apparent, observed with a scanning electron microscope (product name: TM-1000, Hitachi High-Technologies Corporation) of 200 magnifications, and the crack rate on each test substrate was calculated. The number of evaluated chips was ten, the crack rate of a component was measured for the larger one of crack rates of the left and right electrodes, and evaluated as follows . The results are listed in Table 6 to Table 8.

The crack rate is the index of the degree of the region having a crack with reference to the estimated crack length. In the present test, the condition of the crack occurred in each test substrate was observed, the full length of the crack was estimated, and the crack rate was calculated by the following formula.

```
Crack rate (%) = (total crack length / total length of
estimated line crack) x 100
```

The "total length of estimated line crack" refers to the length of completely ruptured crack. The crack rate is obtained by dividing the total length of the multiple generated cracks by the length of the estimated route of crack progression.

⊚: Average of crack rate is 50% or less
○: Average of crack rate is more than 50% and 80% or less
∆: Average of crack rate is more than 80% and 90% or less
✕: Average of crack rate is more than 90% and 100% or less

(2) Alloy layer crack test (from -40°C to 150°C)

Each test substrate was made under the same conditions as the solder crack test (1).
Subsequently, the target part of each test substrate was cut out, and sealed with an epoxy resin (product name: EPOMOUNT (main agent and curing agent), Refine Tec Ltd.). Furthermore, using a wet polishing machine (product name: TegraPol-25, Marumoto Struers K.K.) the central cross section of the chip component mounted on each test substrate was made apparent, observed with a scanning electron microscope (product name: TM-1000, Hitachi High-Technologies Corporation) at 200 magnifications, the presence or absence of the occurrence of cracks in the alloy layer of the solder joint caused by thermomigration phenomenon as depicted in Fig. 1 was observed, and the rate of occurrence of cracks in the alloy layer of 20 lands on the ten chips was evaluated as follows. The results are listed in Table 6 to Table 8.

⊚: The rate of occurrence of cracks is 0% or more and 25% or less
○: The rate of occurrence of cracks is more than 25% and 50% or less
✕: The rate of occurrence of cracks is more than 50% and 100% or less

(3) Void test

Test substrates were made under the same conditions as those in the (1) Solder crack test except that the solder pastes A and the solder pastes B were used, using a chip component with a size of 2.0 mm x 1.2 mm, a glass epoxy substrate including a solder resist having a pattern for mounting a chip component of the size and an electrode for connecting the chip component (1.25 mm x 1.0 mm), and a metal mask with a thickness of 150 $\mu$m having the same pattern.
Subsequently, the surface state of each test substrate was observed with an X-ray inspection apparatus (product name: SMX-160E, Shimadzu Co., Ltd.), the area ratio of voids in the region under the electrode of the chip component in the solder joint of each test substrate (the region indicated with (a) in Fig. 2) (the proportion of the total void area; hereinafter the same) and the area ratio of voids in the area having a filet (the region indicated with (b) in Fig. 2) was measured. The average of the area ratio of voids in 20 lands on the test substrates was determined, and evaluated as follows. The results of the solder pastes A are listed in Table 6 to Table 8, and the results of the solder pastes B are listed in Table 9.

⊚: Average of the area ratio of voids is 3% or less, and inhibitory effect on void generation is very good
○: Average of the area ratio of voids is more than 3% and 5% or less, and inhibitory effect on void generation is good
∆: Average of the area ratio of voids is more than 5% and 8% or less, and inhibitory effect on void generation is sufficient
✕: Average of the area ratio of voids is more than 8%, and inhibitory effect on void generation is insufficient

(4) Voltage application moisture-resistant test

In accordance with JIS Z3284, the solder pastes A were individually printed on JIS 2 comb-shaped electrode substrates (conductor width: 0.318 mm, conductor interval: 0.318 mm, size: 30 mm x 30 mm) using a metal mask (that having slits corresponding to the electrode pattern; thickness: 100 $\mu$m).
Thereafter, the substrates were heated using a reflow furnace (product name: TNP40-577PH, TAMURA Corporation), thereby obtaining test substrates. The reflow conditions at this time were as follows: preheating at 170°C to 180°C for 75 seconds, peak temperature was 230°C, the period at 220°C or higher was 30 seconds, the cooling rate from the peak temperature to 200°C was from 3°C to 8°C/second, and the oxygen concentration was adjusted to 1500 ± 500 ppm.
Subsequently, the test substrates were placed in a constant temperature and constant humidity testing machine (product name: compact environment testing machine SH-641, ESPEC CORP.) adjusted at a temperature of 85°C and a relative humidity of 95%, and after the temperature and humidity in the constant temperature and constant humidity testing machine reached the setting value, the insulation resistance value after two hours was measured as the initial value. Thereafter, application of a voltage of 100 V was started, the insulation resistance values from the initial measurement to 1,000 hours after were measured every one hour, and evaluated according to the following criteria. The results are listed in Table 6 to Table 8.

⊙: All the insulation resistance values from the initial value to the measurements until 1,000 hours are 1.0 x $10^{10}$ Ω or more

○: All the insulation resistance values from the initial value to the measurements until 1,000 hours are 5.0 x $10^9$ Ω or more and less than 1.0 x $10^{10}$ Ω

×: All the insulation resistance values from the initial value to the measurements until 1,000 hours are less than 5.0 x $10^9$ Ω

[Table 6]

| | Solder crack | Alloy layer crack | Void | | Moisture resistance under application of voltage |
| --- | --- | --- | --- | --- | --- |
| | | | Under electrode | Fillet | |
| Example 1 | ○ | ⊙ | ○ | ○ | ○ |
| Example 2 | ○ | ⊙ | ○ | ○ | ○ |
| Example 3 | ○ | ○ | Δ | Δ | ○ |
| Example 4 | ○ | ⊙ | ○ | ○ | ○ |
| Example 5 | ○ | ⊙ | ○ | ○ | ○ |
| Example 6 | ○ | ⊙ | ○ | ○ | ⊙ |
| Example 7 | ○ | ⊙ | Δ | ○ | ⊙ |
| Example 8 | ○ | ⊙ | Δ | Δ | ○ |
| Example 9 | ○ | ⊙ | Δ | Δ | ○ |
| Example 10 | ○ | ⊙ | Δ | ○ | ○ |
| Example 11 | ○ | ⊙ | Δ | ○ | ○ |
| Example 12 | ○ | ⊙ | Δ | ○ | ○ |
| Example 13 | ○ | ⊙ | ○ | ○ | ○ |
| Example 14 | ○ | ⊙ | ○ | ○ | ○ |
| Example 15 | ○ | ⊙ | ○ | ○ | ○ |
| Example 16 | ○ | ⊙ | Δ | ○ | ○ |
| Example 17 | Δ | ⊙ | Δ | Δ | ○ |
| Example 18 | ○ | ⊙ | Δ | Δ | ○ |
| Example 19 | Δ | ⊙ | ○ | ○ | ○ |
| Example 20 | Δ | ⊙ | Δ | Δ | ⊙ |
| Example 21 | ○ | ⊙ | Δ | Δ | ⊙ |
| Example 22 | ○ | ⊙ | ○ | ○ | ○ |

[Table 7]

| | Solder crack | Alloy layer crack | Void | | Moisture resistance under application of voltage |
| --- | --- | --- | --- | --- | --- |
| | | | Under electrode | Fillet | |
| Example 23 | ○ | ⊙ | ○ | ○ | ○ |
| Example 24 | ⊙ | ⊙ | ○ | ○ | ○ |
| Example 25 | ⊙ | ⊙ | ⊙ | ○ | ○ |
| Example 26 | ⊙ | ⊙ | ○ | ○ | ○ |

(continued)

| | Solder crack | Alloy layer crack | Void | | Moisture resistance under application of voltage |
| | | | Under electrode | Fillet | |
|---|---|---|---|---|---|
| Example 27 | ⊙ | ⊙ | ○ | ○ | ⊙ |
| Example 28 | ⊙ | ⊙ | ○ | ○ | ○ |
| Example 29 | ⊙ | ⊙ | ○ | ○ | ○ |
| Example 30 | Δ | ⊙ | ⊙ | ○ | ○ |
| Example 31 | Δ | ⊙ | Δ | Δ | ○ |
| Example 32 | ○ | ⊙ | ○ | Δ | ⊙ |
| Example 33 | Δ | ⊙ | Δ | Δ | ○ |
| Example 34 | ○ | ⊙ | ○ | Δ | ○ |
| Example 35 | Δ | ⊙ | ○ | ○ | ○ |
| Example 36 | ○ | ⊙ | ○ | Δ | ⊙ |
| Example 37 | ⊙ | ⊙ | ○ | ○ | ○ |
| Example 38 | ⊙ | ⊙ | ○ | ○ | ○ |
| Example 39 | ⊙ | ⊙ | ○ | ○ | ○ |
| Example 40 | ⊙ | ⊙ | Δ | ○ | ○ |
| Example 41 | ⊙ | ⊙ | ○ | ○ | ○ |
| Example 42 | ⊙ | ⊙ | Δ | ○ | ○ |
| Example 43 | ⊙ | ⊙ | Δ | ○ | ○ |

[Table 8]

| | Solder crack | Alloy layer crack | Void | | Moisture resistance under application of voltage |
| | | | Under electrode | Fillet | |
|---|---|---|---|---|---|
| Comparative Example 1 | × | ⊙ | ○ | ○ | × |
| Comparative Example 2 | × | × | ○ | ○ | × |
| Comparative Example 3 | × | × | ○ | ○ | × |
| Comparative Example 4 | × | ⊙ | Δ | ○ | ○ |
| Comparative Example 5 | × | × | × | × | ○ |
| Comparative Example 6 | × | × | ○ | ○ | × |
| Comparative Example 7 | × | ⊙ | Δ | Δ | ⊙ |
| Comparative Example 8 | × | ⊙ | × | × | ○ |

(continued)

| | Solder crack | Alloy layer crack | Void | | Moisture resistance under application of voltage |
| --- | --- | --- | --- | --- | --- |
| | | | Under electrode | Fillet | |
| Comparative Example 9 | × | ⊙ | × | × | ○ |
| Comparative Example 10 | × | ⊙ | ○ | ○ | ○ |
| Comparative Example 11 | × | ⊙ | × | Δ | ○ |
| Comparative Example 12 | × | ⊙ | ⊙ | ○ | ○ |
| Comparative Example 13 | × | ⊙ | × | Δ | ○ |
| Comparative Example 14 | × | ⊙ | × | Δ | ○ |
| Comparative Example 15 | × | ⊙ | × | Δ | ○ |
| Comparative Example 16 | × | ⊙ | × | Δ | ○ |
| Comparative Example 17 | × | ⊙ | × | Δ | ○ |
| Comparative Example 18 | × | ⊙ | × | Δ | ○ |
| Comparative Example 19 | × | ⊙ | × | Δ | ○ |

[Table 9]

| | Void | |
| --- | --- | --- |
| | Under electrode | Fillet |
| Example 1 | ○ | ⊙ |
| Example 2 | ○ | ⊙ |
| Example 3 | ○ | ○ |
| Example 4 | ⊙ | ⊙ |
| Example 5 | ⊙ | ⊙ |
| Example 6 | ⊙ | ○ |
| Example 7 | ○ | ○ |
| Example 8 | ○ | Δ |
| Example 9 | ○ | ○ |
| Example 10 | ○ | ⊙ |
| Example 11 | ○ | ⊙ |
| Example 12 | ○ | ○ |
| Example 13 | ⊙ | ○ |

(continued)

|  | Void | |
| --- | --- | --- |
|  | Under electrode | Fillet |
| Example 14 | ⊙ | ○ |
| Example 15 | ⊙ | ○ |
| Example 16 | ○ | ○ |
| Example 22 | ○ | ○ |
| Example 23 | ⊙ | ○ |
| Example 24 | ⊙ | ⊙ |
| Example 25 | ⊙ | ⊙ |
| Example 26 | ⊙ | ⊙ |
| Example 27 | ⊙ | ○ |
| Example 28 | ⊙ | ⊙ |
| Example 29 | ⊙ | ○ |

As indicate above, all of the above Examples achieved good solder crack inhibition, alloy layer crack inhibition, void inhibition, and insulation resistance. In particular, since the solder paste B including the lead-free solder alloy powder of the present invention and the flux B includes the solder alloy powder containing In of the present invention, the solder paste B can achieve equivalent crack inhibition, alloy layer crack inhibition, void inhibition, and insulation resistance to those of the solder paste A, and further can improve void inhibitory effect as indicated in Table 9.

As described above, the lead-free solder alloy and solder paste of the present invention is suitably used for electronic circuit boards required to have high reliability, such as in-vehicle electronic circuit boards. Furthermore, these electronic circuit boards are suitably used for electronic controllers required to have further higher reliability.

**Claims**

1.  A lead-free solder alloy comprising 1% by mass or more and 4% by mass or less of Ag, 0.1% by mass or more and 1% by mass or less of Cu, 1.5% by mass or more and 5% by mass or less of Sb, 1% by mass or more and 6% by mass or less of In, the balance including Sn.

2.  The lead-free solder alloy according to claim 1, which further comprises 1% by mass or more and 5.5% by mass or less of Bi.

3.  A lead-free solder alloy comprising 1% by mass or more and 4% by mass or less of Ag, 0.1% by mass or more and 1% by mass or less of Cu, 1.5% by mass or more and 5% by mass or less of Sb, 1% by mass or more and 6% by mass or less of In, 1% by mass or more and 5.5% by mass or less of Bi, the balance comprising Sn, the contents of Ag, Cu, Sb, In, and Bi (% by mass) satisfying all the following formulae (A) to (C).

$$(A)\ 0.84 \le (\text{Ag content}/4) + \text{Cu content} \le 1.82$$

$$(B)\ 0.71 \le (\text{In content}/6) + (\text{Sb content}/5) \le 1.67$$

$$(C)\ 0.29 \le (\text{Bi content}/5) + (\text{Sb content}/5) \le 1.79$$

4.  The lead-free solder alloy according to any one of claim 1 to claim 3, which further comprises at least one of Fe, Mn, Cr, and Mo in a total amount of 0.001% by mass or more and 0.05% by mass or less.

**EP 3 593 937 A1**

5. The lead-free solder alloy according to any one of claim 1 to claim 4, which further comprises at least one of P, Ga, and Ge in a total amount of 0.001% by mass or more and 0.05% by mass or less.

6. A solder paste comprising the lead-free solder alloy according to any one of claim 1 to claim 5 and a flux composition.

7. An electronic circuit board having a solder joint formed using the lead-free solder alloy according to any one of claim 1 to claim 5.

**19**

[FIG. 1]

L  x200  500 um

[FIG. 2]

(a)

(b)

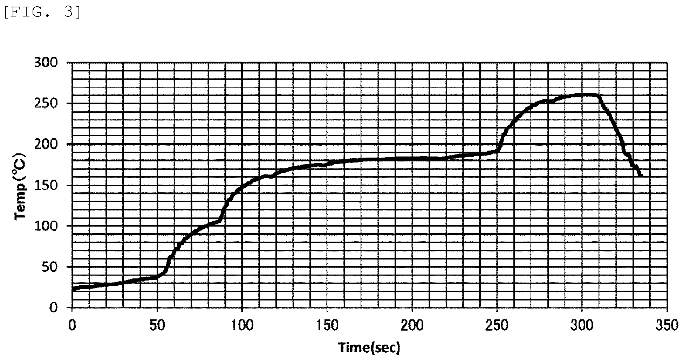

[FIG. 3]

# INTERNATIONAL SEARCH REPORT

| International application No. |
|---|
| PCT/JP2018/008723 |

## A. CLASSIFICATION OF SUBJECT MATTER
Int. Cl. B23K35/26(2006.01)i, C22C13/00(2006.01)i, C22C13/02(2006.01)i, H05K3/34(2006.01)i

According to International Patent Classification (IPC) or to both national classification and IPC

## B. FIELDS SEARCHED

Minimum documentation searched (classification system followed by classification symbols)
Int. Cl. B23K35/26, C22C13/00, C22C13/02, H05K3/34

Documentation searched other than minimum documentation to the extent that such documents are included in the fields searched
Published examined utility model applications of Japan      1922-1996
Published unexamined utility model applications of Japan    1971-2018
Registered utility model specifications of Japan            1996-2018
Published registered utility model applications of Japan    1994-2018

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | CN 1398697 A (DENG, Hesheng) 26 February 2003, | 1, 7 |
| A | table JW-3 (Family: none) | 2-6 |
| A | WO 97/09455 A1 (DAVID SARNOFF RESEARCH CENTER, INC.) 13 March 1997, page 4, lines 27-30, claims 13-14 (Family: none) | 1-7 |
| A | JP 2001-334385 A (HITACHI, LTD.) 04 December 2001 (Family: none) | 1-7 |
| A | JP 2002-120085 A (H TECHNOLOGY GROUP INC.) 23 April 2002 (Family: none) | 1-7 |

☒ Further documents are listed in the continuation of Box C.    ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 22.05.2018 | 29.05.2018 |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2018/008723 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 4787384 B1 (HARIMA CHEMICALS, INC.) 05 October 2011 & US 2012/0175020 A1 & WO 2012/056753 A1 & EP 2468450 A1 & CN 102574251 A & TW 201217543 A1 & MX 2011011353 A | 1-7 |
| A | WO 2012/128356 A1 (SENJU METAL INDUSTRY CO., LTD.) 27 September 2012 & US 2014/0141273 A1 & WO 2012/127642 A1 & EP 2689885 A1 & TW 201343312 A & CN 103561903 A & KR 10-2014-0044801 A & TW 201706068 A & BR 112013024398 A2 | 1-7 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5228685 A
- JP 2012081521 A
- JP 7171696 A
- JP 7178590 A